# EUROPEAN PATENT APPLICATION

(11) **EP 4 521 409 A1**
(43) Date of publication of application: **12.03.2025**
(21) Application number: 24199201.5
(22) Date of filing: 09.09.2024
(51) Int. Cl.: G11C 29/48, G11C 29/02, G11C 29/12, G11C 29/24, G11C 5/02, G11C 5/06, G11C 29/04, H01L 21/66, H01L 25/065, H01L 25/18

(54) **TESTING ACCESS FOR STACKED SEMICONDUCTOR DEVICES AND ASSOCIATED SYSTEMS AND METHODS**

(30) Priority: 08.09.2023 US 202363537333 P
(71) Applicant: Micron Technology, Inc., Boise, ID 83707-0006 (US)
(72) Inventor: YANG,, Lingming, Boise (US); SREERAMANENI,, Raghukiran, Boise (US); GAJERA,, Nevil N., Boise (US)
(74) Representative: Carpmaels & Ransford LLP

(57) **Abstract**

High-bandwidth memory (HBM) devices and associated systems and methods are disclosed herein. In some embodiments, the HBM devices include a first die (e.g., an interface die), a plurality of second dies (e.g., memory dies) carried by the first die communicably coupled to the first die through a plurality of HBM bus through substrate vias (TSVs). The HBM devices also include an HBM testing component carried at least partially by an upper surface of an uppermost second die. The HBM testing component provides access to the first and second dies through an uppermost surface of the HBM device to test the HBM device during manufacturing. For example, the HBM testing component allows the first and second dies to be tested after the HBM device is mounted to a base substrate of a system-in-package without requiring any footprint for access pins on the base substrate.

## Description

### TECHNICAL FIELD

The present technology is generally related to vertically stacked semiconductor memory devices and more specifically to systems and methods for accessing and testing high bandwidth memory devices in a system-in-package.

### BACKGROUND

Microelectronic devices, such as memory devices, microprocessors, and other electronics, typically include one or more semiconductor dies mounted to a substrate and encased in a protective covering. The semiconductor dies include functional features, such as memory cells, processor circuits, imager devices, interconnecting circuitry, etc. To meet continual demands on decreasing size, wafers, individual semiconductor dies, and/or active components are typically manufactured in bulk, singulated, and then stacked on an interposer and/or a support substrate (e.g., a printed circuit board (PCB) or other suitable substrates). The stacked dies can then be coupled to the interposer and/or the support substrate (sometimes also referred to as a package substrate) through bond wires in shingle-stacked dies (e.g., dies stacked with an offset for each die) and/or through substrate vias (TSVs) between the dies and the support substrate.

### BRIEF DESCRIPTION OF THE DRAWINGS

Fig. 1 is a schematic diagram illustrating an environment that incorporates a high-bandwidth memory architecture.
Fig. 2 is a partially schematic cross-sectional diagram of a system-in-package device.
Fig. 3 is a partially schematic cross-sectional diagram of a high-bandwidth memory device configured in accordance with some embodiments of the present technology.
Fig. 4 is a schematic circuit diagram of an access point for a high-bandwidth memory testing component configured in accordance with further embodiments of the present technology.
Fig. 5 is a partially schematic cross-sectional diagram of a high-bandwidth memory device configured in accordance with further embodiments of the present technology.
Fig. 6A is a partially schematic cross-sectional diagram of a high-bandwidth memory device configured in accordance with further embodiments of the present technology.
Fig. 6B is a partially schematic top view of an HBM testing component configured in accordance with some embodiments of the present technology.
Fig. 7 is a flow diagram of a process for manufacturing a SiP device in accordance with some embodiments of the present technology.

The drawings have not necessarily been drawn to scale. Further, it will be understood that several of the drawings have been drawn schematically and/or partially schematically. Similarly, some components and/or operations can be separated into different blocks or combined into a single block for the purpose of discussing some of the implementations of the present technology. Moreover, while the technology is amenable to various modifications and alternative forms, specific implementations have been shown by way of example in the drawings and are described in detail below. The intention, however, is not to limit the technology to the particular implementations described.

### DETAILED DESCRIPTION

High data reliability, high speed of memory access, lower power consumption, and reduced chip size are features that are demanded from semiconductor memory. In recent years, three-dimensional (3D) memory devices have been introduced. Some 3D memory devices are formed by stacking memory dies vertically, and interconnecting the dies using through-silicon (or through-substrate) vias (TSVs). Benefits of the 3D memory devices include shorter interconnects (which reduce circuit delays and power consumption), a large number of vertical vias between layers (which allow wide bandwidth buses between functional blocks, such as memory dies, in different layers), and a considerably smaller footprint. Thus, the 3D memory devices contribute to higher memory access speed, lower power consumption, and chip size reduction. Example 3D memory devices include Hybrid Memory Cube (HMC) and High Bandwidth Memory (HBM). For example, HBM is a type of memory that includes a vertical stack of dynamic random-access memory (DRAM) dies and an interface die (which, e.g., provides the interface between the DRAM dies of the HBM device and a host device).

In a system-in-package (SiP) configuration, HBM devices may be integrated with a host device (e.g., a graphics processing unit (GPU) and/or computer processing unit (CPU)) using a base substrate (e.g., a silicon interposer, a substrate of organic material, a substrate of inorganic material and/or any other suitable material that provides interconnection between the GPU/CPU and the HBM device and/or provides mechanical support for the components of an SiP device), through which the HBM devices and host communicate. Because traffic between the HBM devices and host device resides within the SiP (e.g., using signals routed through the silicon interposer), a higher bandwidth may be achieved between the HBM devices and host device than in conventional systems. In other words, the TSVs interconnecting DRAM dies within an HBM device, and the silicon interposer integrating HBM devices and a host device, enable the routing of a greater number of signals (e.g., wider data buses) than is typically found between packaged memory devices and a host device (e.g., through a printed circuit board (PCB)). The high-bandwidth interface within a SiP enables large amounts of data to move quickly between the host device (e.g., GPU/CPU) and HBM devices during operation. For example, the high-bandwidth channels can be on the order of 1000 gigabytes per second (GB/s, sometimes also referred to as gigabits (Gb)). It will be appreciated that such high-bandwidth data transfer between a GPU/CPU and the memory of HBM devices can be advantageous in various high-performance computing applications, such as video rendering, high-resolution graphics applications, artificial intelligence and/or machine learning (AI/ML) computing systems and other complex computational systems, and/or various other computing applications.

However, HBM devices can present certain challenges. One such challenge is that there is limited space available on the base substrate to provide pins to access and test the HBM devices after they are integrated with the SiP (e.g., soldered on to the base substrate). As a result, it can be difficult to assess various testing metrics (e.g., the functionality, performance, and other aspects of the HBM devices (and/or the SiP as a whole based on the aspects of one or more HBM devices)) after the HBM devices are integrated with the base substrate. For example, it can be difficult to test a functionality of the HBM devices (e.g., whether the HBM device produces an expected result and/or outcome given an input, responds to a given input, and/or the like), check whether there are defects from the integration process (e.g., broken signal lines), assess the condition of the HBM devices over time, measure various categories of performance (e.g., signal speed, bandwidth, and/or the like), and/or the like. Accordingly, described herein are systems and associated methods that improve access to the HBM devices after they are stacked and integrated with the base substrate.

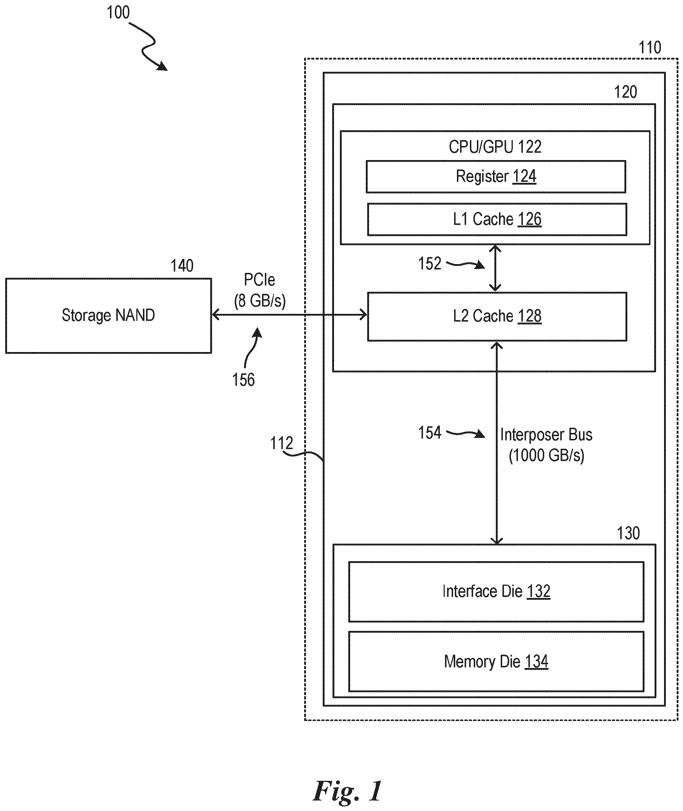

Fig. 1 is a schematic diagram illustrating an environment 100 that incorporates a high bandwidth memory architecture. As illustrated in Fig. 1, the environment 100 includes a SiP device 110 having one or more processing devices 120 (one illustrated in Fig. 1, sometimes also referred to herein as one or more "hosts"), and one or more HBM devices 130 (one illustrated in Fig. 1), integrated with a silicon interposer 112 (or any other suitable base substrate). The environment 100 additionally includes a storage device 140 coupled to the SiP device 110. The processing devices(s) 120 can include one or more CPUs and/or one or more GPUs, referred to as a processing unit 122, each of which may include registers 124 and a first level of cache 126. The first level of cache 126 (also referred to herein as "L1 cache") is communicatively coupled to a second level of cache 128 (also referred to herein as "L2 cache") via a first communication path 152. In the illustrated embodiment, the L2 cache 128 is incorporated into the processing device(s) 120. However, it will be understood that the L2 cache 128 can be integrated into the SiP device 110 separate from the processing device(s) 120. Purely by way of example, the processing device(s) 120 can be carried by a base substrate (e.g., the silicon interposer 112, a package substrate carrying the silicon interposer 112, another suitable organic substrate, an inorganic substrate, and/or any other suitable material) adjacent to the L2 cache 128 and in communication with the L2 cache 128 via one or more signal lines (or other suitable signal route lines) therein. The L2 cache 128 may be shared by one or more of the processing devices 120 (and the processing unit 122 therein). During operation of the SiP device 110, the processing unit 122 can use the registers 124 and the L1 cache 126 to complete processing operations, and attempt to retrieve data from the larger L2 cache 128 whenever a cache miss occurs in the L1 cache 126. As a result, the multiple levels of cache can help accelerate the average time it takes for the processing device(s) 120 to access data, thereby accelerating the overall processing rates.

As further illustrated in Fig. 1, the L2 cache 128 is communicatively coupled to the HBM device(s) 130 through a second communication channel 154. As illustrated, the processing device(s) 120 and HBM device(s) 130 are carried by and electrically coupled (e.g., integrated by) the silicon interposer 112. The second communication channel 154 is provided by the silicon interposer 112 (e.g., the silicon interposer includes and routes the interface signals forming the second communication channel, such as through one or more redistribution layers (RDLs)). As additionally illustrated in Fig. 1, the L2 cache 128 is also communicatively coupled to a storage device 140 through a third communication channel 156. As illustrated, the storage device 140 is outside of the SiP device 110 and utilizes signal routing components that are not contained within the silicon interposer 112 (e.g., between a packaged SiP device 110 and packaged storage device 140). For example, the third communication channel 156 may be a peripheral bus used to connect components on a motherboard or PCB, such as a Peripheral Component Interconnect Express (PCIe) bus. As a result, during the operation of the SiP device 110, the processing device(s) 120 can read data from and/or write data to the HBM device(s) 130 and/or the storage device 140, through the L2 cache 128.

In the illustrated environment 100, the HBM devices 130 include an interface die 132 and one or more stacked memory dies 134 (e.g., DRAM dies, one illustrated schematically in Fig. 1) coupled to the second communication channel 154. As explained above, the HBM device(s) 130 can be located on the silicon interposer 112, on which the processing device(s) 120 are also located. As a result, the second communication channel 154 can provide a high bandwidth (e.g., on the order of 1000 GB/s) channel through the silicon interposer 112. Further, as explained above, each HBM device(s) 130 can provide a high bandwidth channel (not shown) between interface die 132 and/or the memory dies 134 therein. As a result, data can be communicated between the processing device(s) 120 and the HBM device(s) 130 (and components thereof) at high speeds, which can be advantageous for data-intensive processing operations. Purely by way of example, the interface die 132 can be a logic die that receives various read/write requests from the processing device(s) 120, reads/writes to the memory dies 134 in response to the requests, performs any necessary processing, and responds to the processing device(s) 120. During each read/write operation, the SiP device 110 uses a high bandwidth communication channel, allowing the read/write requests to be communicated and responded to on the order of milliseconds (e.g., in real-time).

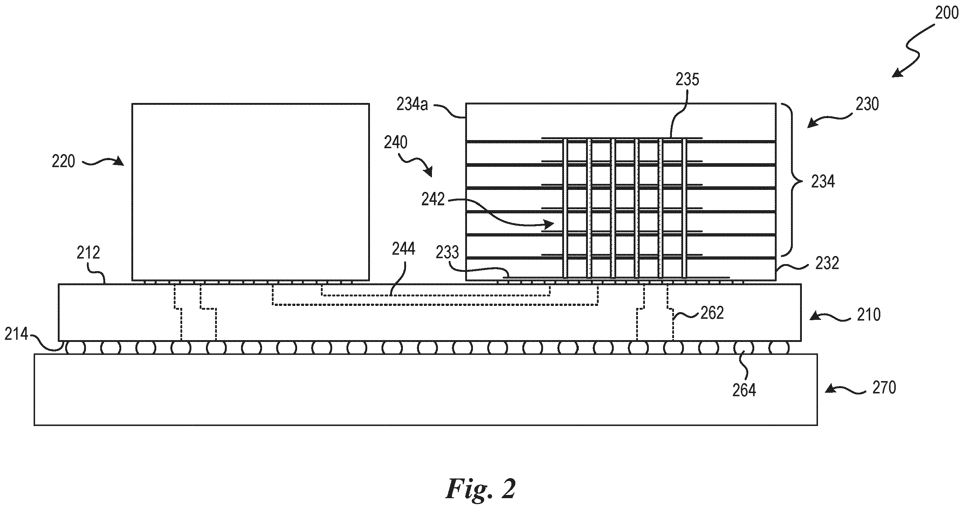

Fig. 2 is a partially schematic cross-sectional diagram of a SiP device 200. As illustrated in Fig. 2, the SiP device 200 includes a base substrate 210 (e.g., a silicon interposer, another organic interposer, an inorganic interposer, and/or any other suitable base substrate), as well as a processing device 220 and an HBM device 230 each integrated with an upper surface 212 of the base substrate 210. Further, the base substrate 210 is carried by (and coupled to) a package substrate 270. In the illustrated environment, the processing device 220, and associated components (e.g., the processing unit (e.g., CPU/GPU), registers, L1 cache, and the like) are illustrated as a single package, and the HBM device 230 includes a stack of semiconductor dies. The stack of semiconductor dies in the HBM device 230 includes an interface die 232 and one or more memory dies 234 (six illustrated in Fig. 2). The processing device 220 is coupled to the HBM device 230 through an HBM bus 242 and a substrate bus 244 (collectively forming a high bandwidth bus 240). The HBM bus 242 includes a plurality of active through substrate vias ("active TSVs") extending from a metallization layer 233 in the interface die 232 to a metallization layer 235 in an uppermost memory die 234a. The active TSVs in the HBM bus 242 allow each of the dies in the HBM device 230 to communicate data (e.g., between the memory dies 234 (e.g., DRAM dies) and the interface die 232) at a relatively high rate (e.g., on the order of 1000 GB/s or greater). The substrate bus 244 includes one or more route lines (two illustrated schematically in Fig. 2) formed into (or on) the base substrate 210. In various embodiments, the route lines of the substrate bus 244 can include one or more metallization layers formed in one or more RDL layers of the base substrate 210 and/or one or more vias interconnecting the metallization layers. As further illustrated schematically in Fig. 2, the processing device 220 and the HBM device 230 can each be coupled to the substrate bus 244 via solder structures (e.g., solder balls), metal-metal bonds, and/or any other suitable conductive bonds. As a result, components of the HBM device 230 and the processing device 220 can communicate data at a relatively high rate (e.g., on the order of 1000 GB/s or greater).

As further illustrated in Fig. 2, the base substrate 210 can further include one or more external TSVs 262 (four illustrated in Fig. 2) that extend from the upper surface 212 of the base substrate 210 to a lower surface 214 (sometimes also referred to herein as an "inner surface") of the base substrate 210. The external TSVs 262 can couple the processing device 220, the HBM device 230, and/or the substrate bus 244 to package interconnects 264 (e.g., solder structures, bond pads, and/or the like). The package interconnects 264 are coupled between the base substrate 210 and the package substrate, thereby physically and electrically coupling the SiP device 200 to the package substrate 270.

During manufacturing of the SiP device 200, the processing device 220 and the HBM device 230 are each stacked on and coupled to the base substrate 210, which is then stacked on and coupled to the package substrate. Each stacking process includes steps that can undermine the functionality of the HBM device 230 (e.g., by damaging components of the HBM bus 242, circuits in the interface die 232 and/or the memory dies 234, and the like such that the HBM device 230 does not respond to inputs, does not respond as expected, and/or is slower to respond to inputs than expected (or required)). Accordingly, it can be advantageous to test the HBM device 230 (and/or the processing device 220) after various stages of manufacturing to ensure the HBM device 230 is functioning properly. If not, the HBM device 230 can be replaced and/or the SiP device 200 can be recycled, thereby avoiding further processing on the SiP device 200 when it will not meet operate correctly. However, industry demands continuously push for increased density in computational power. As a result, the footprint of the SiP device 200 is continuously shrinking. Additionally, or alternatively, space on the base substrate 210 is increasingly occupied by route lines in the substrate bus 244 and/or other active components of the SiP device 200. As a result, there is less room on the base substrate 210 for pins to access and test the HBM device 230.

HBM devices, and associated systems and methods, that address the shortcomings discussed above are disclosed herein. For example, the HBM devices can include a first die (e.g., an interface die), a plurality of second dies (e.g., memory dies) carried by the first die communicably coupled to the first die through a plurality of HBM bus through substrate vias (TSVs). The HBM devices also include an HBM testing component carried at least partially by an upper surface of an uppermost second die. The HBM testing component provides access to the first and second dies (and components therein) through an outer surface of the HBM device (e.g., an uppermost surface). For example, as described herein, the uppermost surface of the HBM testing component can include bond pads communicatively coupled to one or more locations internal to the HBM device (e.g., circuits of the first and second dies). As a result, the HBM testing component allows the HBM device to be tested at various stages of manufacturing and/or integration. For example, the HBM testing component allows the operation of the first and second dies (and the connection of the dies) to be tested after the HBM device is mounted to the base substrate (e.g., the base substrate 210 of Fig. 2) without requiring additional footprint for access pins on the base substrate.

In some embodiments, the HBM testing component is a passive component that establishes communication routes between the outer surface of the HBM device and the first and second dies. In such embodiments, an external testing component (e.g., a processing unit or other controller) can access components of the HBM device through the passive communication routes to evaluate the HBM device (e.g., observe/probe values, and/or set values, internal to the HBM device). In some such embodiments, the HBM testing component can include a redistribution layer carried by (and/or formed on) the upper surface of the uppermost second die and a testing TSV extending from the redistribution layer to an active circuit region of the first die. The testing TSV can be communicably couplable to one or more circuits (e.g., test circuits, active circuits, and/or the like) in the active circuit region. Further, the HBM testing component can also include a bond pad carried by an outermost surface of the redistribution layer, thereby establishing access to the circuits in the active circuit region at the outermost surface of the HBM device. In some embodiments, the HBM testing component includes a passthrough die attached to the upper surface of the uppermost second die. The passthrough die can include the redistribution layer, allowing the passthrough die (and the redistribution layer) to be manufactured in bulk separate from the second dies and/or without modifying the manufacturing process for the second dies.

In some embodiments, the HBM testing component can include one or more active circuits and/or other active elements. For example, the HBM testing component can include a copy of at least some of the circuits of the interface die, one or more test-driving circuits, and/or the like. The copy of the circuits from the interface die can allow the HBM testing component to directly access and assess memory dies in the HBM device (e.g., checking the response time of each of the memory dies, confirming the functionality of the HBM bus, and/or the like). Additionally, or alternatively, the copy of the circuits from the interface die can allow the HBM testing component to act as a backup interface die if the circuits in the interface die are damaged.

Additional details on the systems and methods for improving access to vertically-stacked memory devices, such as HBM devices, are set out below. For ease of reference, semiconductor systems (and their components) are sometimes described herein with reference to front and back, top and bottom, upper and lower, upwards and downwards, and/or horizontal plane, x-y plane, vertical, or z-direction relative to the spatial orientation of the embodiments shown in the figures. It is to be understood, however, that the semiconductor systems (and their components) can be moved to, and used in, different spatial orientations without changing the structure and/or function of the disclosed embodiments of the present technology.

Further, although the semiconductor systems disclosed herein are primarily discussed in the context of access to an HBM device, one of skill in the art will understand that the scope of the technology is not so limited. For example, the systems and methods disclosed herein can also be deployed to improve access to active components and/or functional dies in other stacked semiconductor devices, to improve access to other components of the SiP, and the like.

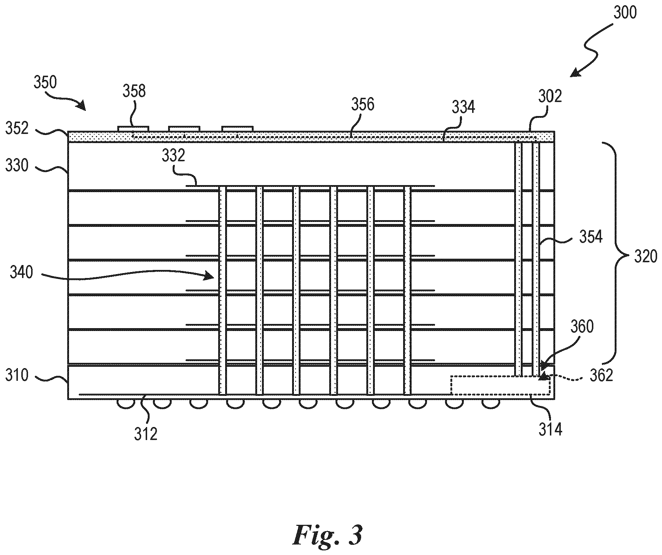

Fig. 3 is a partially schematic cross-sectional diagram of an HBM device 300 configured in accordance with some embodiments of the present technology. As illustrated in Fig. 3, the HBM device 300 is generally similar to the HBM device 230 of Fig. 2. For example, the HBM device 300 includes an interface die 310 and a plurality of memory dies 320 carried by the interface die 320. The HBM device 300 also includes a plurality of bus TSVs 340 that each extend from a metallization layer 312 in the interface die 310 to a metallization layer 332 in an uppermost memory die 330. As discussed above, the bus TSVs 340 establish a high bandwidth HBM bus interconnecting each of the memory dies 320 with the interface die 310.

In the illustrated embodiment, the HBM device 300 also includes an HBM testing component 350 positioned to provide access to the interface die 310 through an uppermost surface 302 of the HBM device 300. In the illustrated embodiment, the HBM testing component 350 (sometimes also referred to herein as an "access component," "testing unit," and/or the like) includes a redistribution layer 352 carried by an upper surface 334 of the uppermost memory die 330 and one or more testing TSVs 354 extending from the redistribution layer 352, through the memory dies 320, to a circuit region 314 in the interface die 310. In the interface die 310, the testing TSVs 354 (sometimes also referred to herein as "access TSVs") can be coupled to one or more circuits (e.g., active and/or critical circuits for the interface die, testing circuits, and/or any other suitable circuits) and/or one or more signal route lines in the circuit region 314. At the redistribution layer 352, the testing TSVs 354 can be coupled to one or more route lines 356 (one illustrated schematically). The route lines 356, in turn, can be coupled to one or more bond pads 358 (three illustrated in Fig. 3) in the redistribution layer 352. Through these connections, the HBM testing component 350 provides access to and/or control of components in the circuit region 314 of the interface die 310 through the uppermost surface 302 of the HBM device 300.

As a result, the HBM testing component 350 can allow various suitable components to test various components of the HBM device 300. For example, the HBM testing component 350 can allow a controller (or processor) to access test circuits, functional circuits, etc. in the interface die 310 to observe the signals of the accessed circuits and ensure that the accessed circuits are intact after the HBM device 300 is integrated with a base substrate (e.g., the base substrate 210 of Fig. 2). It will be appreciated that by observing particular circuits (e.g., test circuits, functional circuits, etc.) using the HBM testing component 350, a controller may be able to evaluate the operation of the HBM device 300 and interface die 310 therein. Further, in some embodiments, the controller can extrapolate from an observed functionality and/or performance of a subset of the circuits (e.g., the test circuits) on the HBM device 300 to an estimated functionality and/or performance of other circuits (e.g., functional circuits, critical circuits, etc.) on the HBM device 300. In another example, the HBM testing component 350 can allow the controller (or processor) to directly access and test (e.g., send and receive signals to and from) one or more of the critical circuits. In yet another example, the HBM testing component 350 can provide access to one or more signal-routing lines within the HBM device 300 (e.g., within the metallization layer 312 in the interface die 310, lines forming a portion of the HBM bus, and/or the like) to observe (e.g., passively read signals) the signal-routing lines. In this example, the HBM testing component 350 allows one or more measurement devices to read signals in the signal-routing lines while the HBM device 300 is operated by a processing unit (e.g., under the control of the processing device 220 of Fig. 2) to confirm that the HBM device 300 is appropriately responding to the processing unit.

The access and testing is accomplished through the uppermost surface 302 of the HBM device 300 in each of the examples discussed above. As a result, no additional space is required on the base substrate (e.g., the base substrate 210 of Fig. 2) for additional access pins to test the HBM device 300 after it is mounted to the base substrate. Further, the access provided by the HBM testing component 350 can be relatively high-bandwidth access (e.g., on the order of hundreds or thousands of Gb/s) as compared to the access available through pins on the base substrate. Accordingly, the HBM testing component 350 can both help increase the access to components of the HBM device 300 after the HBM device 300 is mounted to the base substrate and help reduce the overall footprint of the base substrate (and the corresponding SiP device).

The HBM testing component 350 can take advantage of the space available on the upper surface 334 of the uppermost memory die 330 to provide access to the HBM device 300 at a relatively low cost. For example, the redistribution layer 352 can be formed on the upper surface 334 of the uppermost memory die 330 during a wafer-level process without significant changes to the manufacturing process. Further, the testing TSVs 354 can be formed during the wafer-level processes with the only change to add segments to the uppermost memory die 330. As a result, while the bus TSVs 340 extend to a first elevation within the uppermost memory die 330 (e.g., the elevation of the metallization layer 332 in the uppermost memory die 330), the testing TSVs 354 extend to a second elevation above the first elevation. Further, as illustrated in Fig. 3, the second elevation can be at (or above) the upper surface 334 of the uppermost memory die 330.

As further illustrated schematically in Fig. 3, the HBM device 300 can also include a coupling mechanism 362 at an access point 360 between the testing TSVs 354 and components in the circuit region 314 (e.g., circuit nodes to be observed and/or controlled). In various embodiments, the coupling mechanism 362 can be a fuse, a fuse switch disconnector, a mask-editable component, and/or any other suitable component. The coupling mechanism 362 can disconnect the testing TSVs 354 from the components in the circuit region 314 to avoid parasitic loading of the components, caused by the testing TSVs, after the HBM device 300 has been tested (e.g., to avoid loading the components during normal use of the HBM device 300 and the corresponding SiP device). As a result, the coupling mechanism 362 can help reduce deleterious effects (if any) associated with the inclusion of the HBM testing component 350.

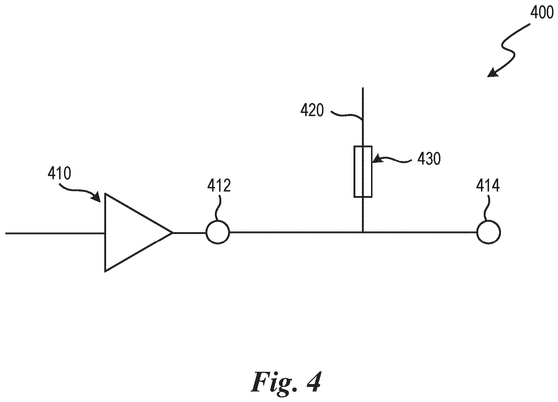

Fig. 4 is a schematic circuit diagram of an access point 400 for an HBM testing component configured in accordance with further embodiments of the present technology. The access point 400 is where a testing TSV 420 (e.g., one of the testing TSVs 354 of Fig. 3) is coupled to a circuit 410 in an interface die (e.g., the interface die 310 of Fig. 3). In the illustrated embodiment, the testing TSV 420 is coupled to a route line between a first node 412 and a second node 414. The first node is coupled to the circuit 410 (e.g., a testing circuit manufactured in the interface die, a critical circuit, a peripheral circuit, and/or any other suitable circuit) while the second node 414 can be coupled to a signal route line and/or one or more additional circuits. As a result, the testing TSV 420 can write signals onto the route line between the first and second nodes 412, 414 (e.g., to control the circuit 410 and/or any other suitable component). Additionally, the testing TSV 420 can read signals moving between the first and second nodes 412, 414 (e.g., to measure activity in the circuit 410 while the corresponding HBM device is operating). However, the connectivity of the testing TSV 420 may apply a small parasitic load to the route line between the first and second nodes 412, 414, even when the testing TSV is not being used (e.g., not being used to control or observe a value). The load, in turn can require additional power during the operation of the HBM device, thereby lowering the efficiency of the HBM device, increasing heat in the HBM device, and/or reducing the lifespan of components of the HBM device (e.g., the circuit 410, the HBM bus, and the like). Additionally, the load may add delay to a functional path associated with the circuit 410, which, for example, can lengthen a critical path.

As a result, it can be advantageous to disconnect the testing TSV 420 from the circuit 410 (and/or other components of the HBM device) after testing has occurred. Therefore, HBM devices configured in accordance with some embodiments of the present technology can include one or more mechanisms to disconnect, uncoupled, etc. testing TSVs 420 from circuits 410. For example, the access point 400 in the illustrated embodiment includes a fuse 430. After the testing has occurred, the testing component and/or the HBM device can over-drive the fuse 430 (e.g., by applying a signal with a current above a predetermined threshold), thereby destroying the fuse 430 and disconnecting the testing TSV 420 from the circuit 410 (and/or other components of the HBM device). As a result, the testing TSV 420 will no longer apply a parasitic load to the HBM device. In some embodiments the fuse 430 may initially be open (e.g., resulting in the testing TSV 420 being disconnected from the circuit 410), and the testing component and/or the HBM device can drive a signal to close the fuse (e.g., to make the connection between the testing TSV and circuit).

In another example (not illustrated), the access point 400 can include a fuse switch disconnector (sometimes also referred to as a fused disconnect switch). The fuse switch disconnector allows the testing TSV 420 to be disconnected from the circuit 410 (and/or other components of the HBM device) after testing is complete and reconnected at a later time (e.g., when diagnosing a malfunctioning SiP). Additionally, the fuse switch disconnector will break if a signal with a sufficient current is loaded onto the testing TSV 420, thereby helping protect the components of the HBM device during testing (e.g., preventing accidental over-driving). In another example, the access point 400 can include a pass gate transistor coupled between the testing TSV 420 and the circuit 410. Similar to the fuse switch, enabling and disabling the pass gate transistor can allow the testing TSV 420 to be selectively disconnected and reconnected from the circuit 410.

In yet another example, the access point 400 can include a mask-editable component that can be altered to disconnect the testing TSV 420 from the circuit 410 (and/or other components of the HBM device). For example, a SiP device having a plurality of HBM devices (or a broader system with a plurality of SiP devices) can include one or more testing-designated HBM devices and one or more non-testing HBM devices. During manufacturing, the components for the testing TSVs can be created in each semiconductor die, allowing the testing-designated HBM device to be constructed with a testing TSV. However, additional processes can be implemented on one or more of the dies for the non-testing HBM devices to remove the connection between the testing TSV and the native circuits on the interface die at the access point 400 in the non-testing HBM devices. As a result, the testing-designated HBM devices can be used for accessing the HBM device and/or assessing various testing metrics. The testing metrics can then be extrapolated to each of the HBM devices, allowing the testing metrics to be assessed for the non-testing HBM devices without the parasitic losses associated with the testing TSVs.

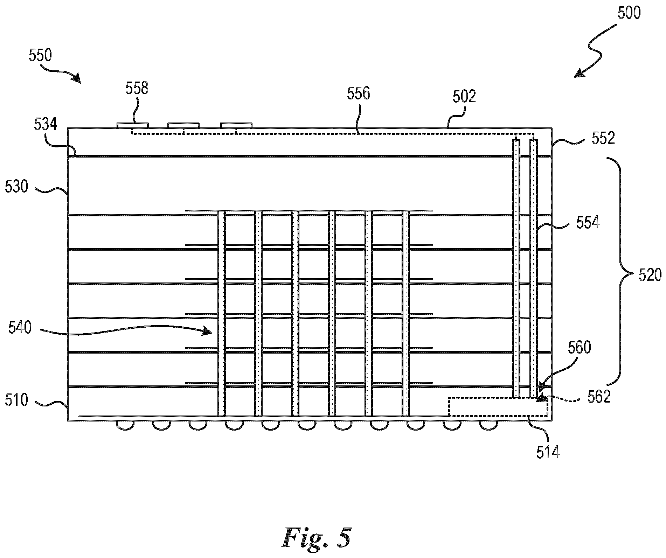

Fig. 5 is a partially schematic cross-sectional diagram of an HBM device 500 configured in accordance with further embodiments of the present technology. As illustrated in Fig. 5, the HBM device 500 is generally similar to the HBM device 300 discussed above with reference to Fig. 3. For example, the HBM device 500 includes an interface die 510, a plurality of memory dies 520 carried by the interface die 510, a plurality of bus TSVs 540 extending from the interface die 510 to an uppermost memory die 530, and an HBM testing component 550 positioned to be communicably coupled to the interface die 510.

In the illustrated embodiment, the HBM testing component 550 includes a passthrough die 552 carried by an upper surface 534 of the uppermost memory die 530 and one or more testing TSVs 554 (two illustrated in Fig. 5) coupled between a circuit region 514 of the interface die 510 and the passthrough die 552. The passthrough die 552 is a passive die with few (or no) circuits for testing the interface die 510 (and/or any other suitable component). Instead, the passthrough die 552 includes one or one or more route lines 556 (e.g., forming a redistribution layer on the passthrough die 552) and one or more bond pads 558 coupled to the route lines 556. The testing TSVs 554 extend to (and/or at least partially through) the passthrough die 552 and are coupled to the route lines 556 (e.g., to an elevation above the upper surface 534 of the uppermost memory die 530), thereby establishing a conductive path between the bond pads 558 and the circuit region 514 in the interface die 510 and providing access to the circuit region 514 through the uppermost surface 502 of the HBM device 500. As a result, the HBM testing component 550 can allow various suitable components to test various components of the HBM device 500. For example, similar to the HBM testing component 350 of Fig. 3, the HBM testing component 550 can allow a controller (or processor) to access test circuits in the interface die 510 to ensure the test circuits are intact; allow the controller (or processor) to directly access and test one or more of the critical circuits; provide access to one or more signal-routing lines within the HBM device to observe the signal-routing lines; and/or the like.

The inclusion of a separate die (e.g., as opposed to forming a redistribution layer on the upper surface 534 of the uppermost memory die 530) for the passthrough die 552 can help accelerate manufacturing. For example, rather than requiring additional stages of wafer-level processing while forming the uppermost memory die 530, the passthrough die 552 can be manufactured in a separate wafer-level process simultaneous with any of the memory dies 520. Accordingly, although the passthrough die 552 may increase costs (compared to forming a redistribution layer on the upper surface 534 of the uppermost memory die 530), the passthrough die 552 can increase the throughput of the manufacturing process.

As further illustrated in Fig. 5, the HBM device 500 can also include a coupling mechanism 562 at an access point 560 between the testing TSVs 554 and components in the circuit region 514. As discussed above, the coupling mechanism 562 can include a fuse, a fuse switch disconnector, a mask-editable component, and/or any other suitable component to controllably decouple the testing TSVs 554 and components in the circuit region 514.

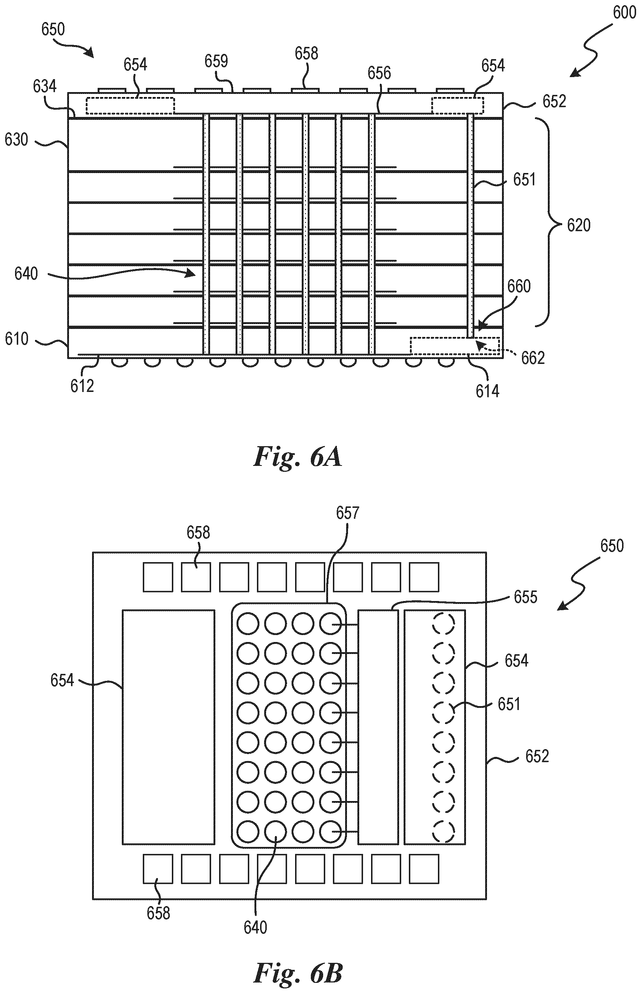

In each of the embodiments discussed above, the HBM testing components (e.g., the HBM testing component 350 illustrated in Fig. 3 and the HBM testing component 550 illustrated in Fig. 5) is a passive component that provides access to circuits and other components of the interface die through the uppermost surface of the HBM device. The passive HBM testing component allows an external testing component to be coupled to and/or control the HBM device through the uppermost surface (e.g., it provides signal access, to internals of the HBM device, to some other active component). In some embodiments, however, the HBM testing component can include one or more active circuits. Fig. 6A is a partially schematic cross-sectional diagram of an HBM device 600 configured in accordance with some such embodiments of the present technology. As illustrated in Fig. 6A, the HBM device 600 is generally similar to the HBM devices 300, 500 discussed above with reference to Figs. 3 and 5. For example, the HBM device 600 includes an interface die 610, a plurality of memory dies 620 carried by the interface die 610, a plurality of bus TSVs 640, and an HBM testing component 650 positioned to be communicably coupled to the interface die 610.

In the illustrated embodiment, however, the HBM testing component 650 includes an additional die 652 carried by an upper surface 634 of an uppermost memory die 630. The additional die 652 includes various built-in circuits 654, one or more metallization layers 656 (one illustrated) coupled to the built-in circuits 654, and one or more external bond pads 658 (eight illustrated) carried by a top surface 659 of the additional die 652 and coupled to the metallization layers 656. Further, the bus TSVs 640 extend from a metallization layer 612 in the interface die 610, through the uppermost memory die 630, to one of the metallization layers 656 in the additional die 652 (e.g., to an elevation above the upper surface 634 of the uppermost memory die 630). As a result, the built-in circuits 654 in the additional die 652 have access to each of the memory dies 620 and/or components of the interface die 610 through the bus TSVs 640.

The built-in circuits 654 can include various circuits designed to test components of the HBM device 600, copies of one or more (including all) of the circuits in the interface die, circuits that measure activity in the HBM device when operated, and/or any other suitable circuits. In a specific, non-limiting example, the built-in circuits 654 include a copy of each of the critical circuits in the interface die (sometimes also referred to herein as "key circuits" and/or "functional circuits"). In this example, a processing unit (or other controller) can be coupled to the external bond pads 658 to access and instruct the built-in circuits 654. The built-in circuits 654 can then send and receive messages from one or more (or all) of the memory dies 620, execute various processing functions, and the like to confirm the operability of built-in circuits 654 and/or the other components of the HBM device 600. When the built-in circuits 654 are sufficiently intact (e.g., meeting various testing metrics), the processing unit can assume the critical circuits on the interface die 610 are also intact (e.g., since they were subject to the same manufacturing processes). Further, in this example, the built-in circuits 654 can provide backups for the critical circuits on the interface die 610 (e.g., when the critical circuits are damaged, as the critical circuits wear out over time, and the like).

While the inclusion of the additional die 652 can increase manufacturing costs (e.g., by requiring the formation and inclusion of the additional die), the functionality of the additional die 652 can both improve the access to components of the HBM device 600 during manufacturing and improve the lifespan of the HBM device 600. For example, as discussed above, the built-in circuits 654 in the additional die 652 can provide backups to the critical circuits in the interface die 610. Additionally, or alternatively, the built-in circuits 654 can periodically test components of the HBM device 600 and report on their condition (e.g., to a processing unit on a corresponding SiP device), allowing the HBM device 600 to receive maintenance for and/or stop using damaged components.

As further illustrated in Fig. 6A, the HBM testing component 650 can include one or more testing TSVs 651 (one illustrated) that are coupled to an active circuit region 614 of the interface die 610 at an access point 660. The testing TSVs 651 can supplement the access provided by the bus TSVs 640 and/or provide direct access to one or more circuits in the circuit region 614. The direct access can allow, for example, a test circuit in the built-in circuits 654 to observe the operation of a critical circuit in the circuit region 614 while the HBM device 600 is operating. The observation can allow the built-in circuits to assess the interface die 610 during a testing phase and/or periodically measure the condition of the interface die 610 during the lifetime of the HBM device 600. As further illustrated in Fig. 6A, similar to the access points discussed above, the access point 660 includes a coupling mechanism 662 between the testing TSV 651 and components in the circuit region 614 that can controllably decouple the testing TSV 651 and components in the circuit region 614.

Fig. 6B is a partially schematic top view illustrating additional details on the HBM testing component 650 of Fig. 6A in accordance with some embodiments of the present technology. As discussed above, the HBM testing component 650 can include an additional die 652 and one or more testing TSVs 651 (eight illustrated in Fig. 6B) coupled to the additional die 652. Further, as illustrated in Fig. 6B, the additional die 652 can include built-in circuits 654 (e.g., active test circuits), a PHY component 655 (e.g., a transceiver and receiver component), a bus region 657, and a plurality of external bond pads 658. The bus TSVs 640 extend into (and/or through) the additional die 652 in the bus region 657 and are coupled to the PHY component 655. The PHY component 655, in turn, is coupled to the built-in circuits 654 and/or the external bond pads 658 to route signals through and/or out of the additional die 652. For example, during a testing phase, a processing unit (or other suitable controller) can be coupled to one or more of the external bond pads 658. The PHY component 655 can receive commands from the processing unit through the external bond pads 658, then route appropriate signals to the built-in circuits 654 and/or through the bus TSVs 640 toward other components of the HBM device (e.g., toward one or more of the memory dies 620 of Fig. 6A).

In the illustrated embodiment, the bus region 657 is positioned in a central portion of the additional die 652 with the PHY component 655 and external bond pads 658 positioned peripheral to the bus region 657 and the built-in circuits 654 positioned peripheral to the PHY component 655. However, it will be understood that the components of the additional die 652 can be arranged in any other suitable layout. Purely by way of example, the external bond pads 658 can trace an entire perimeter of the additional die 652 to increase the number of possible external connections. In another example, the PHY component 655 can be at least partially integrated with the built-in circuits 654 such that the PHY component 655 and the built-in circuits 654 are both formed within a longitudinal space on the additional die 652.

As further illustrated in Fig. 6B, the testing TSVs 651 can be positioned at least partially (or fully) aligned with (and within the footprint of) the built-in circuits 654. In such embodiments, as discussed above, the testing TSVs 651 can directly couple the built-in circuits 654 to other components of the HBM device (e.g., to components in the circuit region 614 of Fig. 6A). In various other embodiments, however, the testing TSVs 651 can be aligned with the PHY component 655, aligned with one or more of the external bond pads 658, and/or not aligned with any component in of the additional die 652. In a specific, non-limiting example, the testing TSVs 651 can be directly coupled to a subset of the external bond pads 658 to provide an external testing device with direct access (e.g., not through the PHY component 655 and/or any other routing component) to other components of the HBM device (e.g., the circuit region 614 of Fig. 6A).

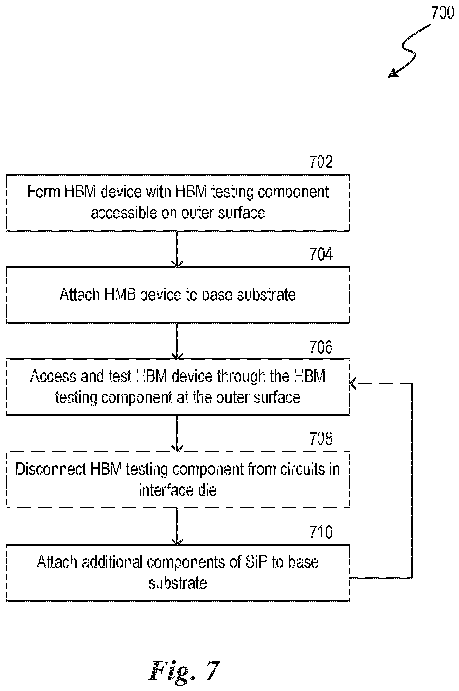

Fig. 7 is a flow diagram of a process 700 for manufacturing a SiP device in accordance with some embodiments of the present technology. The process 700 can be implemented by a single manufacturing apparatus and/or split between multiple manufacturing apparatuses to construct and test the SiP devices.

The process 700 begins at block 702 by forming an HBM device with an HBM testing component accessible (e.g., having one or more external bond pads or other conductive links) on an outer surface of the HBM device (e.g., the uppermost surface 302 of Fig. 3). Forming the HBM component can include stacking each of a plurality of memory dies on an interface die and bonding the die stack together. In various embodiments, the dies can be bonded by a plurality of solder structures, metal-metal bonds between conductive structures (e.g., segments of the TSVs and the like), hybrid bonds (sometimes also referred to as direct bonds), die-attach films, and/or the like.

As discussed above, the HBM testing component can include a redistribution layer formed on an upper surface of an uppermost memory die, an additional passive die carried by and coupled to the uppermost memory die, and/or an additional active die carried by and coupled to the uppermost memory die. In embodiments having an additional active die, forming the HBM device at block 702 can include forming the active die with appropriate circuits (e.g., copies of the critical circuits in the relevant interface die, testing circuits, and/or the like).

At block 704, the process 700 includes attaching the HBM device to a base substrate (e.g., a silicon interposer, another organic interposer, an inorganic interposer, and/or any other suitable base substrate) of the SiP. Attaching the HBM device to the base substrate can include reflowing one or more solder structures between a lower (or inner) surface of the HBM device and the base substrate, forming one or more metal-metal bonds between the lower (or inner) surface and the base substrate, forming one or more hybrid bonds between the lower (or inner) surface and the base substrate, and/or the like. As a result, the attachment process can include applying heat and/or pressure to the HBM device that can undermine the bonds formed between dies therein and/or otherwise damage structures in the HBM device.

Accordingly, at block 706, the process 700 includes accessing and testing the HBM device through the HBM testing component at the outer surface of the HBM device. The testing process can include executing one or more read/write operations to store and retrieve data from the memory dies, one or more data processing requests (e.g., in the interface die and/or an additional active die), and/or the like. The tests allow a processing unit (or other controller) to measure various testing metrics, such as whether the HBM device is function (e.g., whether the HBM device produce the expected result and/or outcome given an input), a speed of the HBM device in responding to read/write requests, an operating temperature of the HBM device, and/or any other suitable operating parameters. As a result, the test allow the processing unit to confirm that the HBM device meets one or more predetermined testing metric requirements and/or was not damaged during the attachment process at block 706.

At optional block 708, the process 700 includes disconnecting (or partially disconnecting) the HBM testing component from circuits (or other components) in the interface die. As discussed above, the disconnect can be implemented by a fuse, a fuse switch disconnector, a switch, a mask-editable component, and/or any other suitable component coupled between a testing TSV and the interface die. Purely by way of example, the processing unit can drive a current through the fuse that is above a predetermined threshold, thereby breaking the fuse and disconnecting the testing TSV from the interface die.

In some embodiments, the process 700 skips optional block 708 and/or implements optional block 708 later in the process. For example, as discussed below, additional rounds of tests can be conducted after mounting other components to the SiP to ensure the additional attachment processes did not damage the HBM device beyond an acceptable level. In another example, the load applied to the interface die through the testing TSVs can be insubstantial and therefore not necessitate a disconnecting process.

At block 710, the process 700 includes attaching additional components of the SiP to the base substrate, such as a processing unit (e.g., the processing device 220 of Fig. 2), additional HBM devices, and/or any other suitable components. Similar to the process 700 at block 704, the attachment at block 710 can include reflowing one or more solder structures, forming one or more metal-metal bonds, forming one or more hybrid bonds, and/or the like. As a result, the attachment process can include applying heat and/or pressure in the vicinity of the HBM device that can undermine the bonds formed between dies therein and/or otherwise damage structures in the HBM device. Accordingly, in some embodiments, the process 700 can return to block 706 to access and test the HBM device through the HBM testing component.

By testing the HBM device after attaching each component of the SiP individually, the process 700 can avoid executing manufacturing steps on a SiP device when the HBM device is damaged. For example, by testing the HBM device after attaching it to the base substrate, the process 700 can detect a faulty HBM device before attaching a processing unit to the base substrate. The detection can then simply the replacement of the HBM device and/or save a processing unit (e.g., when the SiP must be thrown out), thereby reducing the costs of manufacturing. However, it will be understood that, in some embodiments, the process 700 can execute block 706 to test the HBM device only after all of the components of the SiP have been attached to the base substrate, thereby only testing the HBM device only once. By delaying the testing, the process 700 can help streamline the manufacturing process for each SiP device, thereby increasing the throughput of the manufacturing process.

From the foregoing, it will be appreciated that specific embodiments of the technology have been described herein for purposes of illustration, but well-known structures and functions have not been shown or described in detail to avoid unnecessarily obscuring the description of the embodiments of the technology. To the extent any material incorporated herein by reference conflicts with the present disclosure, the present disclosure controls. Where the context permits, singular or plural terms may also include the plural or singular term, respectively. Moreover, unless the word "or" is expressly limited to mean only a single item exclusive from the other items in reference to a list of two or more items, then the use of "or" in such a list is to be interpreted as including (a) any single item in the list, (b) all of the items in the list, or (c) any combination of the items in the list. Furthermore, as used herein, the phrase "and/or" as in "A and/or B" refers to A alone, B alone, and both A and B. Additionally, the terms "comprising," "including," "having," and "with" are used throughout to mean including at least the recited feature(s) such that any greater number of the same features and/or additional types of other features are not precluded. Further, the terms "generally", "approximately," and "about" are used herein to mean within at least 10 percent of a given value or limit. Purely by way of example, an approximate ratio means within 10 percent of the given ratio.

Several implementations of the disclosed technology are described above in reference to the figures. The computing devices on which the described technology may be implemented can include one or more central processing units, memory, input devices (e.g., keyboard and pointing devices), output devices (e.g., display devices), storage devices (e.g., disk drives), and network devices (e.g., network interfaces). The memory and storage devices are computer-readable storage media that can store instructions that implement at least portions of the described technology. In addition, the data structures and message structures can be stored or transmitted via a data transmission medium, such as a signal on a communications link. Thus, computer-readable media can comprise computer-readable storage media (e.g., "non-transitory" media) and computer-readable transmission media.

It will also be appreciated that various modifications may be made without deviating from the disclosure or the technology. For example, the interface die of the HBM device can be located in any other suitable location in the stack. In another example, the HBM testing process can be implemented only after all components of the SiP device are attached to the base substrate (e.g., rather than after each attachment). Further, one of ordinary skill in the art will understand that various components of the technology can be further divided into subcomponents, or that various components and functions of the technology may be combined and integrated. In addition, certain aspects of the technology described in the context of particular embodiments may also be combined or eliminated in other embodiments.

Furthermore, although advantages associated with certain embodiments of the technology have been described in the context of those embodiments, other embodiments may also exhibit such advantages, and not all embodiments need necessarily exhibit such advantages to fall within the scope of the technology. Accordingly, the disclosure and associated technology can encompass other embodiments not expressly shown or described herein.

## Claims

1. A high-bandwidth memory (HBM) device, comprising:
a first die;
a plurality of second dies carried by the first die, the plurality of second dies including an uppermost die, wherein each of the plurality of second dies are communicably coupled to the first die through a plurality of active through substrate vias (TSVs); and
an HBM testing component carried at least partially by an upper surface of the uppermost die and positioned to be communicably coupled to the first die.

2. The HBM device of claim 1 wherein the HBM testing component comprises:
a redistribution layer carried by the upper surface of the uppermost die;
a testing TSV extending from the redistribution layer to an active circuit region of the first die to be communicably coupled to one or more test circuits in the active circuit region; and
a bond pad carried by an outermost surface of the redistribution layer, wherein the bond pad is communicably coupled to the redistribution layer to provide access to the one or more test circuits in the active circuit region at the outermost surface.

3. The HBM device of claim 1 wherein the HBM testing component comprises:
a passthrough die carried by the upper surface of the uppermost die, wherein the passthrough die includes a redistribution layer and an outermost surface;
a testing TSV extending from the redistribution layer of the passthrough die to an active circuit region of the first die to be communicably coupled to one or more test circuits in the active circuit region; and
a bond pad carried by the outermost surface of the passthrough die, wherein the bond pad is communicably coupled to the redistribution layer to provide access to the one or more test circuits in the active circuit region at the outermost surface.

4. The HBM device of claim 1 wherein the first die comprises a plurality of active circuits, and wherein the HBM testing component comprises:
a testing die carried by the upper surface of the uppermost die, the testing die comprising a copy of the plurality of active circuits in the first die, wherein the testing die optionally includes a copy of each active component in the first die; and
a bond pad carried by an outermost surface of the testing die, wherein the bond pad is communicably coupled to the copy of the plurality of active circuits to provide access to the copy of the plurality of active circuits at the outermost surface,
wherein:
the plurality of active TSVs extends from a first metallization layer in the first die to a second metallization layer in the testing die; and
each of the plurality of second dies are further communicably coupled to the testing die through the plurality of active TSVs to establish a communication path between the copy of the plurality of active circuits and the plurality of second dies.

5. The HBM device of claim 1 wherein the first die comprises a plurality of active circuits, and wherein the HBM testing component comprises:
a testing die carried by the upper surface of the uppermost die, the testing die comprising a copy of the plurality of active circuits in the first die;
a bond pad carried by an outermost surface of the testing die, wherein the bond pad is communicably coupled to the copy of the plurality of active circuits to provide access to the copy of the plurality of active circuits at the outermost surface; and
optionally a testing TSV extending from the first metallization layer to the second metallization layer to be communicably coupled between one or more test circuits in the first die and the testing die to provide access to the one or more test circuits at the outermost surface,
wherein:
the plurality of active TSVs extends from a first metallization layer in the first die to a second metallization layer in the testing die; and
each of the plurality of second dies are further communicably coupled to the testing die through the plurality of active TSVs to establish a communication path between the copy of the plurality of active circuits and the plurality of second dies.

6. The HBM device of claim 1 wherein the HBM testing component comprises:
a testing TSV extending from a metallization layer in the first die to an elevation above the upper surface of the uppermost die; and
a fuse communicably coupled between the testing TSV and the metallization layer, optionally wherein the fuse is broken.

7. The HBM device of claim 1 wherein the HBM testing component comprises:
a testing TSV extending from a metallization layer in the first die to an elevation above the upper surface of the uppermost die; and
a fuse switch disconnector communicably coupled between the testing TSV and the metallization layer.

8. A system-in-package (SiP) device, comprising:
an interposer substrate;
a processing unit carried by the interposer substrate; and
a high-bandwidth memory (HBM) device carried by the interposer substrate, wherein the HBM device is coupled to the processing unit by an interposer bus, and wherein the HBM device comprises:
an interface die carried by the interposer substrate;
a plurality of memory dies carried by the interface die, wherein the plurality of memory dies are communicably coupled to the interface die; and
an HBM testing component carried at least partially by an upper surface of an uppermost memory die, the HBM testing component positioned to be communicably coupled to the interface die to provide access to the interface die at an uppermost surface of the HBM device.

9. The SiP device of claim 8 wherein the plurality of memory dies are communicably coupled to the interface die by a plurality of signal through substrate vias (TSVs) extending from the interface die to a first elevation within the uppermost memory die, and wherein the HBM testing component comprises an access TSV extending from the interface die to a second elevation at or above the upper surface of the uppermost memory die.

10. The SiP device of claim 8 wherein the HBM testing component comprises an access through substrate via (TSV) extending from the interface die to an elevation at or above the upper surface of the uppermost memory die, the access TSV positioned to be communicably coupled to one or more testing circuits in the interface die.

11. The SiP device of claim 8 wherein the HBM testing component comprises an additional die carried by the upper surface of the uppermost memory die and an access through substrate via (TSV) extending from the interface die to an elevation within the additional die, and wherein the HBM testing component optionally further comprises one or more bond pads carried by an outer surface of the additional die and one or more redistribution layers communicably coupling the one or more bond pads to the access TSV.

12. The SiP device of claim 8 wherein the HBM testing component includes one or more redistribution layers formed on the upper surface of the uppermost memory die.

13. A method for manufacturing a system-in-package (SiP) device, comprising:
forming a high bandwidth memory (HBM) device, the HBM device comprising:
an interface die;
a plurality of memory dies; and
an HBM testing component accessible at an outer surface of the HBM device;
attaching an inner surface of the HBM device to an interposer;
accessing one or more circuits in the HBM device through the HBM testing component to test one or more testing metrics of the HBM device; and
attaching one or more additional components to the interposer.

14. The method of claim 13, further comprising disconnecting the HBM testing component from the one or more circuits after accessing the one or more circuits to test the one or more testing metrics, wherein disconnecting the HBM testing component optionally comprises over-driving a fuse communicably coupled between the HBM testing component and the one or more circuits.

15. The method of claim 13 wherein forming the HBM device comprises:
forming the HBM testing component on an upper surface of an uppermost memory die from the plurality of memory dies; and
stacking the plurality of memory dies on the interface die with the uppermost memory die on top; or
stacking the plurality of memory dies on the interface die; and
stacking an additional die on an uppermost memory die from the plurality of memory dies, wherein the additional die includes at least one redistribution layer communicably coupling a bond pad on an outermost surface of the additional die to a through substrate via structure in the additional die.
